(19) **Europäisches Patentamt**

**European Patent Office**

**Office européen des brevets**

(11) **EP 1 424 780 B1**

(12) **EUROPEAN PATENT SPECIFICATION**

(45) Date of publication and mention
of the grant of the patent:
**11.10.2006 Bulletin 2006/41**

(51) Int Cl.:
***H03M 7/36*** (2006.01)

(21) Application number: **03257351.1**

(22) Date of filing: **21.11.2003**

(54) **Delta-sigma modulator, method of switching delta-sigma modulator, and digital amplifier**

Delta-Sigma Modulator, Verfahren zur Schaltung eines Delta-Sigma Modulators, und Digitalverstärker

Modulateur delta-sigma, procédé de commutation d'un modulateur delta-sigma, et amplificateur numérique

(84) Designated Contracting States:
**DE FR GB**

(30) Priority: **25.11.2002 JP 2002340745**

(43) Date of publication of application:
**02.06.2004 Bulletin 2004/23**

(73) Proprietor: **Pioneer Corporation**
**Meguro-ku,**
**Tokyo (JP)**

(72) Inventor: **Komamura, Mitsuya,**
**Pioneer Corporation**
**Tsurugashima-shi**
**Saitama (JP)**

(74) Representative: **Haley, Stephen**
**Gill Jennings & Every LLP**
**Broadgate House**
**7 Eldon Street**
**London EC2M 7LH (GB)**

(56) References cited:
**EP-A- 0 512 687       EP-A- 1 130 786**
**US-A- 5 742 246       US-A- 5 757 301**
**US-A- 5 959 562       US-A- 6 064 326**

EP 1 424 780 B1

**Description**

The present disclosure relates to the subject matter contained in Japanese Patent Application No.2002-340745 filed November 25, 2002.

The present invention relates to a delta-sigma modulator, a method of switching a delta-sigma modulator, and a digital amplifier.

Conventionally, a digital amplifier using delta-sigma modulation shifts quantization noise to a high-frequency band by noise shaping, to thereby secure the S/N ratio of an audio band.

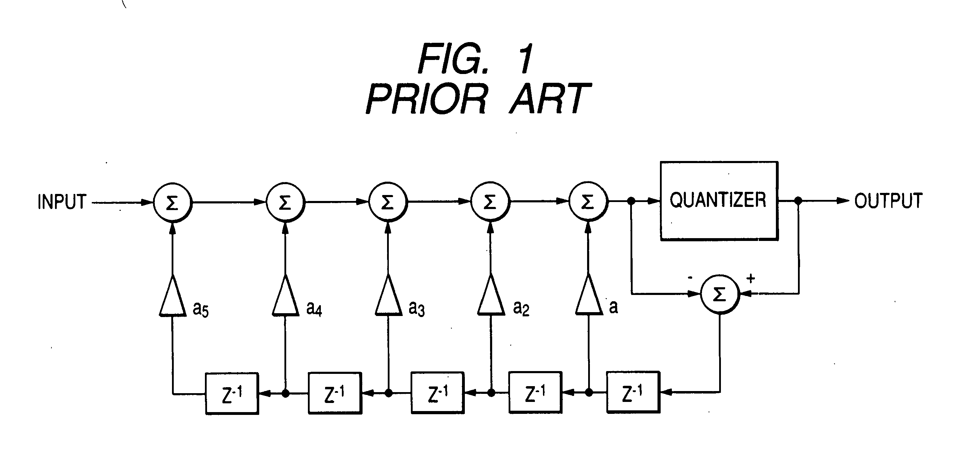

Fig. 1 is a block diagram showing the configuration of a conventional quintic delta-sigma modulator. Noise shaping filter coefficients (a1, a2, a3, a4, a5) are fixed. In this manner, the coefficients of the conventional delta-sigma modulator serving as a noise shaping filter used in a digital amplifier are fixed (e.g., see J.M. Goldberg and A.B. Sandler, "Noise Shaping and Pulse-Width Modulation for an All-Digital Audio Power Amplifier", Journal of the Audio Engineering Society, Vol. 39, No. 6, 1991.).

It should be noted that, although the coefficients of the delta-sigma modulator are fixed in the above-described prior art, there is a modulator that selects the filter coefficients in accordance with an input signal level with the purpose of making the amplitude frequency properties of the quantization noise coincide with the auditory sensitivity properties of humans, and the configuration thereof is shown in Fig. 2 (e.g., see JP-A-7-15281, page 3 and Fig. 1).

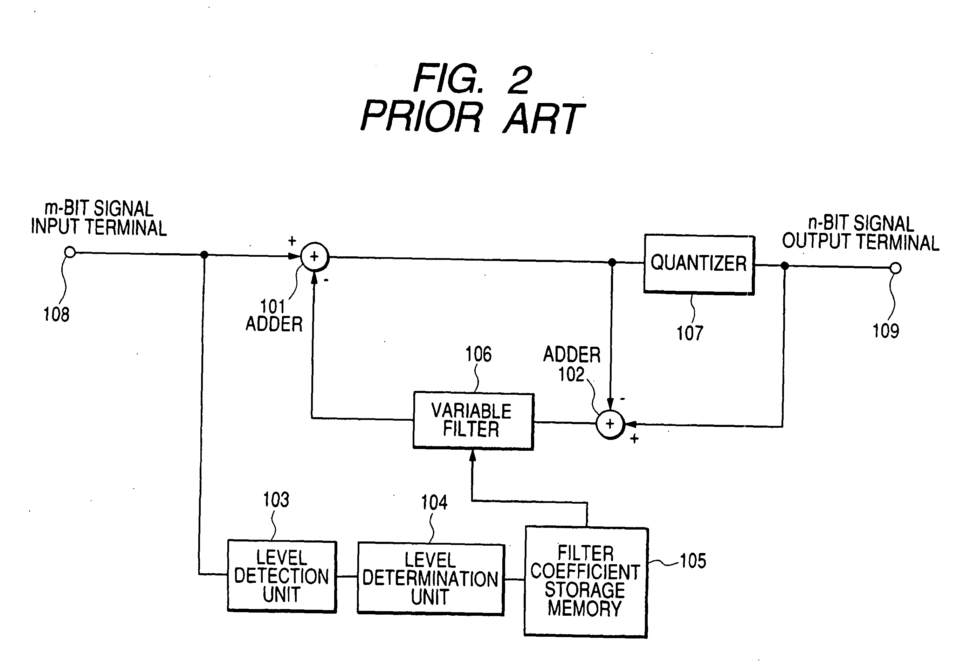

In the prior art shown in Fig. 2, the level of an m-bit input signal is detected by a level detection unit 103, and the result of determination by a level determination unit 104 is input to a filter coefficient storage memory 105. Filter coefficients that make the amplitude frequency properties of quantization noise coincide with auditory sensitivity properties changing in accordance with the level of the m-bit input signal is stored in advance in the filter coefficient storage memory 105. Properties of a variable filter 106 are determined by the filter coefficients selected in accordance with the level determined by the level determination unit 104, and a difference between the output of an adder 101 and an output signal of a quantizer 107 is input to the variable filter 106 and added to the m-bit input signal.

However, there are the following problems in the conventional delta-sigma modulator. In order to raise the S/N ratio, it must be ensured that the amount of noise shaping is increased using a (high-order) delta-sigma modulator of a high-order circuit configuration. However, in a high-order delta-sigma modulator, the system becomes unstable when the amplitude of the input signal becomes large, and sometimes oscillation occurs. As a result, a balance between a high S/N ratio and stabilization of the system cannot be achieved.

Thus, in a case where the filter coefficients are fixed, the maximum amplitude of the input signal must be restricted when a high-order delta-sigma modulator is used in order to raise the S/N ratio. As a result, it becomes necessary to raise the voltage at the power switching stage in order to obtain a predetermined output, which is a disadvantage in terms of performance and costs. Conversely, because a low-order delta-sigma modulator must be used in order to allow an input signal of a large amplitude, it is difficult to raise the S/N ratio.

Also, in the conventional example shown in Fig. 2, the delta-sigma modulator is configured so that an average value of the absolute value of the amplitude of the input signal in a past predetermined period of time is detected, the level of this value is determined, and switching is conducted by the level. However, there are problems in that, because that which is detected is a past level, there is a great potential for the level to have already changed before the filter coefficients are switched, and it is difficult to achieve a balance between a high S/N ratio and stability of the system. These problems can be listed as examples among the problems that the present invention attempts to solve.

US 5757301 discloses a method of restoring delta-sigma modulator to a stable region after it has entered an unstable region.

US 5959562 discloses a delta-sigma modulator for use in quantising an analog input signal.

EP-A-0512687 discloses a modulator where the effective order is reduced outside a reference voltage range.

According to the present invention, there is provided a delta-sigma modulator that shifts quantization noise of a digital audio signal to a high-frequency band to reduce noise of the band of the digital audio signal, the delta-sigma modulator comprising:

a filtering unit configured to have plural sets of filter coefficients having different shaping properties and allowing the quantization noise to pass; and
a filter coefficient switching unit; characterised by:

a quantization bit rate detecting unit configured to detect a quantization bit rate of the digital audio signal; and
a volume setting value detecting unit configured to detect a volume setting value of the digital audio signal;
wherein the filter coefficient switching unit is configured to switch the filter coefficients of the filtering unit in accordance with the detection result of the quantization bit rate detecting unit and the detection result of the volume setting value detecting unit.

According to the present invention, there is further provided a method of switching a delta-sigma modulator to shift quantisation noise of a digital audio signal to a high-frequency band to reduce noise of the digital audio signal, the method characterised by the steps of:

detecting a quantization bit rate of a digital audio signal;
detecting a volume setting value of the digital audio signal; and
switching filter coefficients in accordance with the quantization bit rate and the volume setting value.

In the Drawings;

Fig. 1 is a block diagram showing the configuration of a conventional quintic delta-sigma modulator.
Fig. 2 is a block diagram showing a conventional delta-sigma modulator described in Patent Document 1.
Fig. 3 is a functional block diagram showing a digital amplifier according to an embodiment of the invention.
Fig. 4 is a block diagram showing an example of a delta-sigma modulation circuit configuring a delta-sigma modulator according to the embodiment of the invention.
Fig. 5 is a chart showing noise shaping properties of the delta-sigma modulation circuit of Fig. 4.
Fig. 6 is a block diagram showing the configuration of the delta-sigma modulator according to the embodiment of the invention.
Fig. 7 is a graph showing a threshold and a filter switching point in time when a volume setting rises.
Fig. 8 is a graph showing a threshold and a filter switching point in time when the volume setting falls.
Fig. 9 is a block diagram showing another example of a delta-sigma modulation circuit configuring the delta-sigma modulator according to the embodiment of the invention.
Fig. 10 is a block diagram showing yet another example of a delta-sigma modulation circuit configuring the delta-sigma modulator according to the embodiment of the invention.

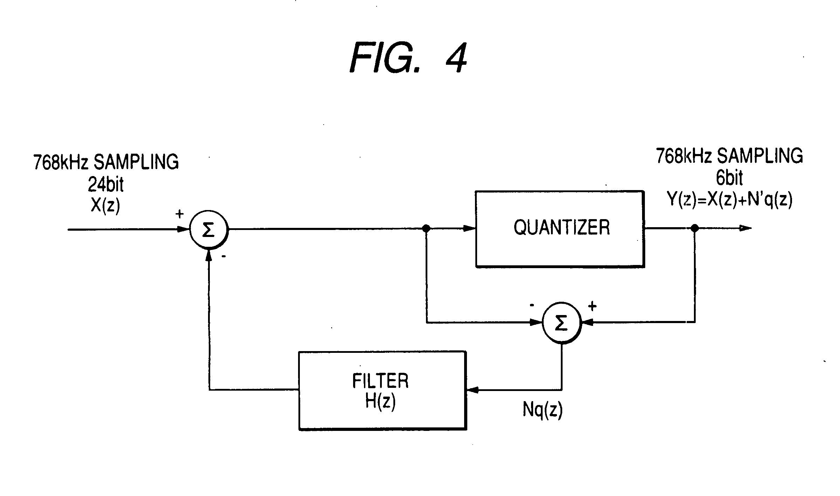

An embodiment according to the invention will be described in detail below on the basis of the drawings.

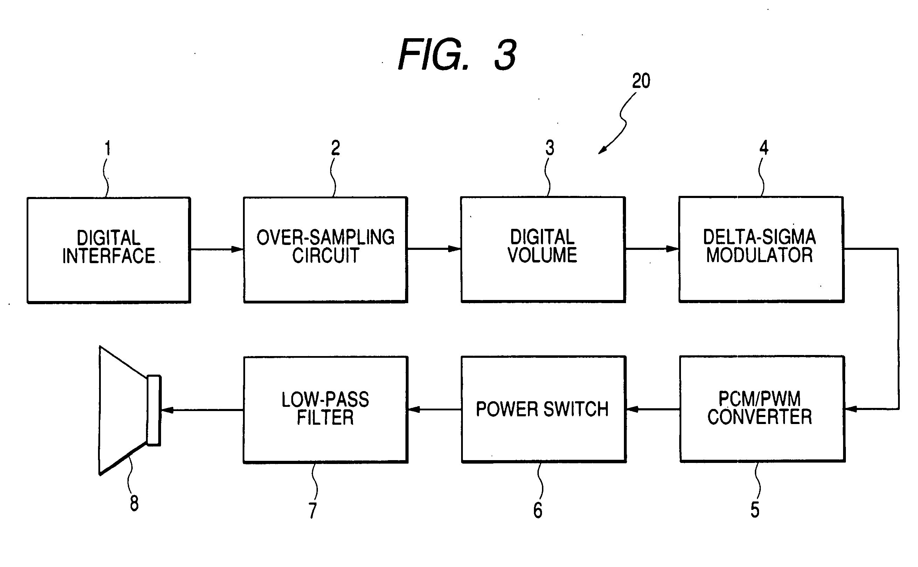

Fig. 3 is a functional block diagram of a digital amplifier using a delta-sigma modulator according to the embodiment of the invention.
In Fig. 3, a digital amplifier 20 using the delta-sigma modulator according to the embodiment of the invention includes: a digital interface 1 that acquires an input signal from a digital source such as a CD (Compact Disc) or a DVD (Digital Versatile Disc); an over-sampling circuit 2 that over-samples the input signal acquired from the digital source via the digital interface 1; a digital volume 3 that adjusts gain with respect to the input signal whose sampling frequency has been raised; a delta-sigma modulator 4 that reduces a quantization bit rate with respect to the gain-adjusted input signal; a PCM (Pulse Code Modulation)/PWM (Pulse Width Modulation) convertor 5 that converts a pulse code modulation signal obtained by the delta-sigma modulator 4 into a pulse width modulation signal; a power switch 6 that switches an unillustrated power source using the period of the pulse width modulation signal, amplifies the amplitude of the pulse width modulation signal and generates a current applied to a speaker 8; and a low-pass filter 7 that removes the high-band component included in the generated current.
Next, the delta-sigma modulator according to the embodiment of the invention will be described.
First, an example of a delta-sigma modulation circuit making up the delta-sigma modulator 4 according to the embodiment of the invention is shown in Fig. 4, and the basic configuration and operation thereof will be described.
As shown in Fig. 4, the delta-sigma modulation circuit includes an adder E, a filter and a quantizer. In Fig. 4, quantization noise Nq(z) is fed back to an input side via the filter H(z). As a result, the spectrum of the quantization noise is transformed by the following equation.

$$Nq'(z) = (1 - H(z)) Nq(z) \qquad (1)$$

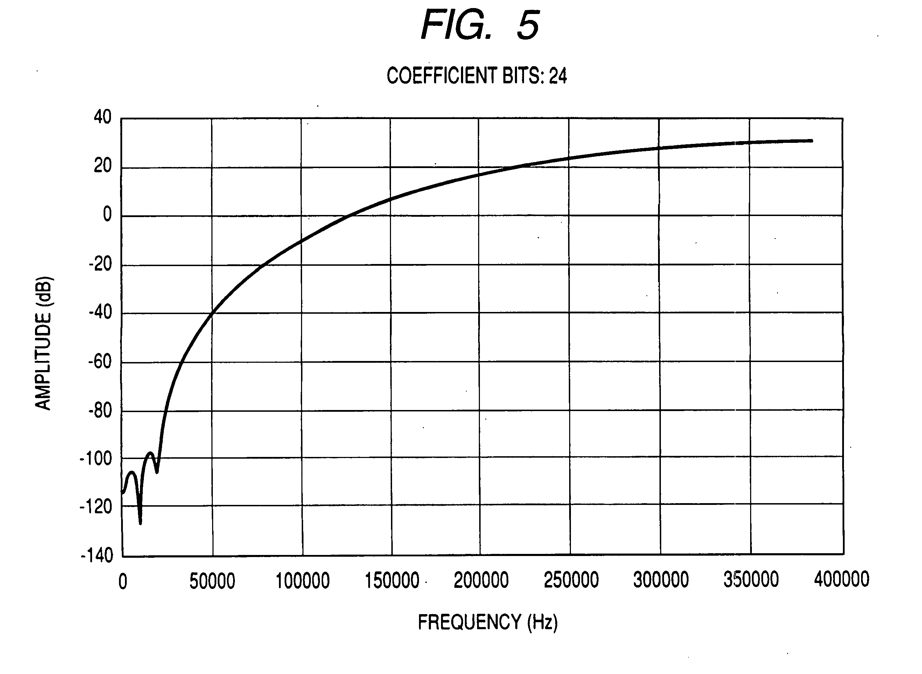

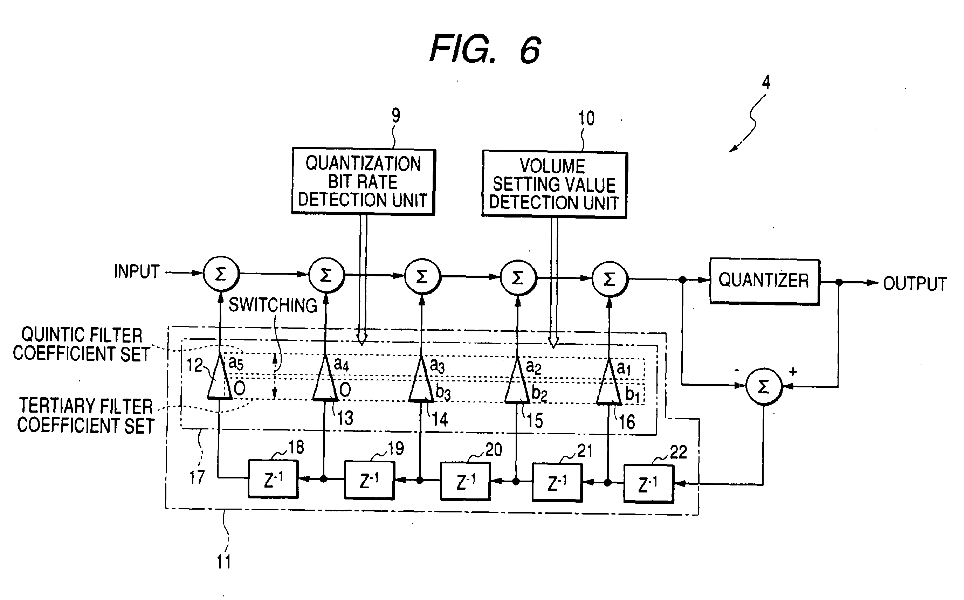

Here, for example, when a 24-bit signal of 768 kHz is input, a 6-bit output signal Y(z) is output. Ordinarily, in the digital amplifier, the filter H(z) is appropriately designed and, as shown in the noise shaping property graph shown in Fig. 5, the quantization noise is shifted to a high-frequency band, whereby the noise of the audio band is reduced and the S/N ratio is secured.
The delta-sigma modulator 4 according to the embodiment of the invention is configured as shown in Fig. 6 using a quintic delta-sigma modulation circuit (e.g., the circuit shown in Fig. 4).
As shown in Fig. 6, the delta-sigma modulator 4 includes a quantization bit rate detection unit 9 that detects the quantization bit rate of a digital audio signal that is the input source; a volume setting value detection unit 10 that detects a volume setting value of the digital audio signal; a filter 11 that includes plural sets of filter coefficients having different shaping properties and allows the quantization noise to pass; and a filter coefficient switcher 17 that switches the filter coefficients of gain adjustors 12 to 16 of the filter 11 in accordance with the bit rate and the volume setting value of the digital audio signal.

In this manner, because the delta-sigma modulator 4 according to the embodiment of the invention includes a quintic delta-sigma modulation circuit, the number of coefficients for each of delta-sigma conversion circuits is five. Additionally, the delta-sigma modulator 4 is characterized in that it plurally has filter coefficients where the five coefficients are used as one set.

That is, as shown in Fig. 6, the delta-sigma modulator 4 has two sets of filter coefficients: quintic (high-order) filter coefficients (a1, a2, a3, a4, a5) and tertiary (low-order) filter coefficients (b1, b2, b3, 0, 0). In this manner, a tertiary (low-order) delta-sigma converter is realized by the tertiary (low-order) filter coefficients having two 0 coefficients.

As a specific example of the quintic and tertiary filter coefficients used here, an example such as the following numerical values can be given.

Quintic filter coefficients: (-5, 10, -10, 5, -1)

Tertiary filter coefficients: (-3, 3, -1, 0, 0)

The filter coefficient switcher 17 always switches the filter coefficients to the tertiary filter coefficient set (b1, b2, b3, 0, 0) in the case of a source having a low quantization bit rate such as a CD, and in principle switches the filter coefficients to the quintic filter coefficients (a1, a2, a3, a4, a5) in the case of a source having a high quantization bit rate such as a DVD. However, the tertiary filter coefficients are used in a case where the volume setting value is set higher than a threshold value, which is lower than the maximum value thereof by a predetermined value, even in the case of a source with a high quantization bit rate.

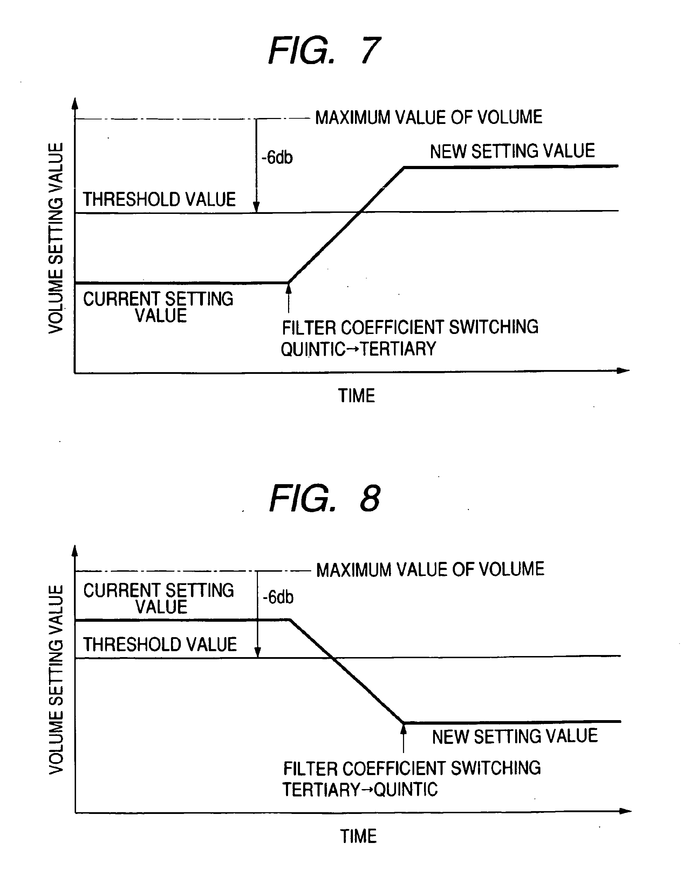

At the time that the volume setting value rises, as in Fig. 7 that shows the threshold value and the point in time where the filter coefficients are switched, the filter coefficients are switched from quintic (high-order) to tertiary (low-order) when the volume setting value that had been set lower than the predetermined threshold value is changed to a value higher than the threshold value.

Conversely, at the time that the volume setting value falls, as in Fig. 8 that shows the threshold value and the point in time where the filter coefficients are switched, the filter coefficients are switched from tertiary (low-order) to quintic (high-order) when the volume setting value that had been set higher than the predetermined threshold is changed to a value lower than the threshold.

Assuming, for example, that the maximum value of the volume setting is 0 dB, the threshold shown in Figs. 7 and 8 is preferably about -6 dB. The reason for this is because oscillation occurs when the input amplitude is not held to about 60% or less of the maximum value of the volume setting value with the quintic filter coefficients.

Also, when the filter coefficients are switched from tertiary to quintic, the filter coefficient switcher 17 resets memories 18 to 22 storing the quantization noise to zero.

The reason for this is to prevent the quantization noise from being excessively fed back when the filter coefficients are switched from the tertiary filter coefficient set to the quintic filter coefficient set, because the numerical values of the quintic filter coefficients are larger than those of the tertiary filter coefficients, as in the specific example of the numerical values mentioned above.

It should be noted that it is not necessary to reset the memories when the filter coefficients are switched from quintic to tertiary. However, because a control program is required in order to ensure that the memories are not reset, here, the memories may be reset in order to simplify the overall control program.

Moreover, when the gain rises from a current volume setting value shown in Fig. 7 to a new volume setting value, the filter coefficients are switched from quintic (high-order) to tertiary (low-order) near the point in time when the rising starts. When the gain falls from the current volume setting shown in Fig. 8 to a new volume setting, the filter coefficients are switched from tertiary (low-order) to quintic (high-order) near the point in time when the falling ends.

By switching the filter coefficients near the point in time when the rising starts and near the point in time when the falling ends, the high-order filter coefficient set is always used with a volume setting value that is lower than the threshold (predetermined value). Thus, the system can be prevented from becoming unstable.

Next, the operation of the digital amplifier according to the present embodiment will be described.

After the over-sampling circuit 2 has raised the sampling frequency of the input signal from a digital source such as a CD or a DVD acquired via the digital interface 1, the digital volume 3 adjusts the gain.

Then, the delta-sigma modulator 4 reduces the quantization bit rate of the gain-adjusted input signal. After the pulse code modulation signal obtained by the delta-sigma modulator 4 has been converted into the pulse width modulation signal by the PCM/PWM converter 5, the unillustrated power source is switched by the power switch 6 using the period of the pulse width modulation signal, the amplitude of the pulse width modulation signal is amplified, and the current applied to the speaker 8 is generated. After the high-frequency component of the generated current has been removed by the low-pass filter 7, the current is applied to the speaker 8.

Then, in the delta-sigma modulator 4, the filter coefficients are switched to the tertiary filter coefficient set in the case of a source whose input signal has a low quantization bit rate and switched to the quintic filter coefficient set in the case of a source having a high quantization bit rate.

In the case of a source having a high quantization bit rate, the filter coefficients are switched from quintic to tertiary when the volume setting value of the digital volume 3 has been changed to a value of about 50% or more of the maximum value thereof.

Also, the memories storing the quantization noise are reset to zero when the filter coefficients are switched from tertiary to quintic.

In this manner, the delta-sigma modulator 4 detects the quantization bit rate of the input signal (quantization bit rate detection step), switches the filter coefficients to the tertiary filter coefficient set in the case of a source having a low quantization bit rate, and switches the filter coefficients to the quintic filter coefficient set in the case of a source having a high quantization bit rate (filter coefficient switching step). Thus, with respect to a source having a low quantization bit rate, the S/N ratio that the source has can be secured even with a tertiary delta-sigma modulator, and the system does not become unstable even if the amplitude of the input signal becomes large. Additionally, with respect to a source having a high quantization rate, the S/N ratio can be set high by the delta-sigma modulator 4 operating as a quintic delta-sigma modulator.

Also, even in the case of a source having a high quantization bit rate, the delta-sigma modulator 4 detects the volume setting value (volume setting detecting step) and switches the filter coefficients from quintic to tertiary when the value thereof has been changed to a high value of 50% or more of the maximum value (filter coefficient switching step). Thus, because the high-order filter coefficient set is always used with a volume setting that is lower than the threshold, the system can be prevented from becoming unstable.

It should be noted that, because it is rare for the volume value to approach the maximum value, a high S/N ratio can be secured in an ordinary state of use.

Also, the memories storing the quantization noise are reset to zero when the filter coefficients are switched to the high-order coefficients. Thus, the quantization noise can be prevented from being excessively fed back even when the filter coefficients are switched from the tertiary filter coefficient set to the quintic filter coefficient set.

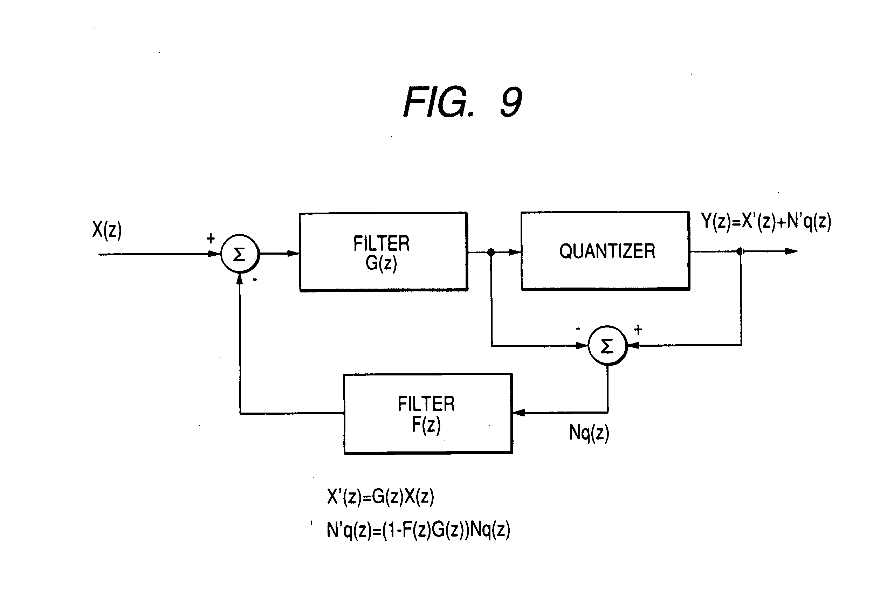

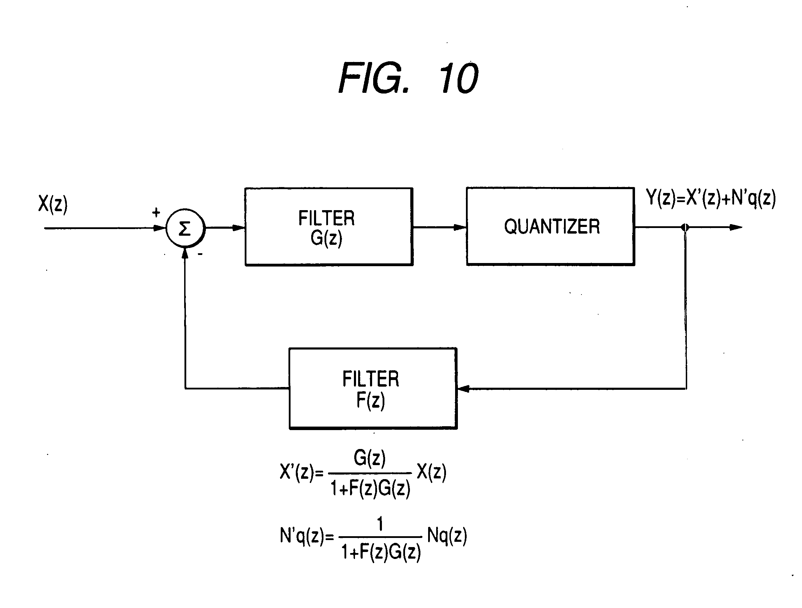

As other examples of the delta-sigma modulation circuit, there are the circuits shown in Figs. 9 and 10. In the delta-sigma modulation circuits shown in these diagrams, not only the quantization noise but the signal have transfer functions. Thus, although the frequency properties of the signals are not flat, filter coefficient switching can also be applied to delta-sigma modulation circuits of such configurations as in the delta-sigma modulator according to the present embodiment.

As described in detail above, the delta-sigma modulator according to the present embodiment is a delta-sigma modulator that shifts quantization noise of a digital audio signal to a high-frequency band to thereby reduce noise of a band of the digital audio signal. The delta-sigma modulator includes the quantization bit rate detection unit 9 that detects the quantization bit rate of the digital audio signal; the volume setting value detection unit 10 that detects the volume setting value of the digital audio signal; the filter 11 that includes plural sets of filter coefficients having different shaping properties and allows the quantization noise to pass; and the filter coefficient switcher 17 that switches the filter coefficients of the filter 11 in accordance with the detection result of the quantization bit rate detection unit 9 and the detection result of the volume setting value detection unit 10. Thereby, the delta-sigma modulator can switch the filter coefficients of the filter 11 in accordance with the detected value of the quantization bit rate of the input signal and the volume setting value. Thus, the delta-sigma modulator can switch the filter coefficients to the low-order coefficient set in the case of an input signal having a low quantization bit rate and can switch the filter coefficients to the high-order coefficient set in the case of an input signal having a high quantization bit rate. The system does not become unstable even if the amplitude of the input signal becomes large. Also, with respect to an input signal having a high quantization bit rate, the S/N ratio can be set high because the delta-sigma modulator operates as a high-order delta-sigma modulator.

Also, the method of switching the delta-sigma modulator according to the present embodiment includes the quantization bit rate detecting step that detects the quantization bit rate of a digital audio signal; the volume setting detecting step that detects the volume setting value of the digital audio signal; and the filter coefficient switching step that switches the filter coefficients in accordance with the quantization bit rate and the volume setting value. Thus, the filter coefficients can be switched to the low-order coefficient set in the case of an input signal having a low quantization bit rate, and the filter coefficients can be switched to the high-order coefficient set in the case of an input signal having a high quantization bit rate. The system can be prevented from becoming unstable even if the amplitude of the input signal becomes large. Also, with respect to an input signal having a high quantization bit rate, the S/N ratio can be set high.

Also, because the digital amplifier according to the present embodiment includes the delta-sigma modulator of the present embodiment, a balance between a high S/N ratio and stability can be achieved.

**Claims**

**1.** A delta-sigma modulator (4) that shifts quantization noise of a digital audio signal to a high-frequency band to reduce noise of the band of the digital audio signal, the delta-sigma modulator comprising:

a filtering unit (11) configured to have plural sets of filter coefficients having different shaping properties and allowing the quantization noise to pass; and
a filter coefficient switching unit (17); **characterised by**:

a quantization bit rate detecting unit (9) configured to detect a quantization bit rate of the digital audio signal; and
a volume setting value detecting unit (10) configured to detect a volume setting value of the digital audio signal;
wherein the filter coefficient switching unit is configured to switch the filter coefficients of the filtering unit in accordance with the detection result of the quantization bit rate detecting unit and the detection result of the volume setting value detecting unit.

2. The delta-sigma modulator (4) according to claim 1, wherein:

the filter coefficients include a first coefficient set and a second coefficient set;
an order of the first coefficient set is lower than that of the second coefficient set; and
the filter coefficient switching unit (17) switches the filter coefficients to the first coefficient set when the quantization bit rate is equal to or less than a predetermined number.

3. The delta-sigma modulator (4) according to claim 1, wherein:

the filter coefficients include a first coefficient set and a second coefficient set;
an order of the first coefficient set is lower than that of the second coefficient set;
the filter coefficient switching unit switches the filter coefficients to the first coefficient set when the quantization bit rate is equal to or greater than a predetermined number and the volume setting value is equal to or greater than a predetermined value; and
the filter coefficient switching unit switches the filter coefficients to the second filter coefficient set when the quantization bit rate is equal to or greater than the predetermined number and the volume setting value is less than the predetermined value.

4. The delta-sigma modulator (4) according to claim 1, wherein:

the filtering unit (11) includes a memory, which stores the quantization noise; and
when the filter coefficient switching unit (17) switches the filter coefficients, contents of the memory are reset.

5. The delta-sigma modulator (4) according to claim 1, wherein:

the filtering unit (11) includes a memory, which stores the quantization noise; and
when the filter coefficient switching unit (17) switches the filter coefficients so that an order thereof becomes larger, contents of the memory are reset.

6. The delta-sigma modulator (4) according to claim 1, wherein:

when the volume setting value is changed and gain rises, the filter coefficient switching unit switches the filter coefficients near the point in time when the rising starts; and
when the volume setting value is changed and gain falls, the filter coefficient switching unit switches the filter coefficients near the point in time when the falling ends.

7. A digital amplifier (20) comprising a delta-sigma modulator (20) according to any preceding claim.

8. A method of switching a delta-sigma modulator (4) to shift quantisation noise of a digital audio signal to a high-frequency band to reduce noise of the digital audio signal, the method **characterised by** the steps of:

detecting a quantization bit rate of a digital audio signal;
detecting a volume setting value of the digital audio signal; and
switching filter coefficients in accordance with the quantization bit rate and the volume setting value.

**Patentansprüche**

1. Delta-Sigma-Modulator (4), der Quantisierungsrauschen eines digitalen Audiosignals zu einem Hochfrequenzband verschiebt, um Rauschen des Bandes des digitalen Audiosignals zu reduzieren, wobei der Delta-Sigma-Modulator umfasst:

   eine Filtereinheit (11), die so konfiguriert ist, dass sie mehrere Sätze von Filterkoeffizienten aufweist, die verschiedene Formungseigenschaften haben und das Quantisierungsrauschen durchlassen; und
   eine Filterkoeffizienten-Umschalteinheit (17), **gekennzeichnet durch**:

   eine Quantisierungs-Bitraten-Erfassungseinheit (9), die so konfiguriert ist, dass sie eine Quantisierungs-Bitrate des digitalen Audiosignals erfasst; und
   eine Lautstärke-Einstellwert-Erfassungseinheit (10), die so konfiguriert ist, dass sie einen Lautstärke-Einstellwert des digitalen Audiosignals erfasst;

   wobei die Filterkoeffizienten-Umschalteinheit so konfiguriert ist, dass sie die Filterkoeffizienten der Filtereinheit gemäß dem Erfassungsergebnis der Quantisierungs-Bitraten-Erfassungseinheit und dem Erfassungsergebnis der Lautstärke-Einstellwert-Erfassungseinheit umschaltet.

2. Delta-Sigma-Modulator (4) nach Anspruch 1, wobei
   die Filterkoeffizienten einen ersten Koeffizientensatz und einen zweiten Koeffizientensatz enthalten;
   eine Ordnung des ersten Koeffizientensatzes niedriger eingestellt ist als die des zweiten Koeffizientensatzes; und
   die Filterkoeffizienten-Umschalteinheit (17) den Filterkoeffizienten auf den ersten Koeffizientensatz umschaltet, wenn die Quantisierungs-Bitrate genauso groß ist wie oder kleiner als eine vorgegebene Zahl.

3. Delta-Sigma-Modulator (4) nach Anspruch 1, wobei
   die Filterkoeffizienten einen ersten Koeffizientensatz und einen zweiten Koeffizientensatz enthalten;
   eine Ordnung des ersten Koeffizientensatzes niedriger eingestellt ist als die des zweiten Koeffizientensatzes;
   die Filterkoeffizienten-Umschalteinheit die Filterkoeffizienten auf den ersten Koeffizientensatz umschaltet, wenn die Quantisierungs-Bitrate genauso groß ist wie oder größer als eine vorgegebene Zahl und der Lautstärke-Einstellwert genauso groß ist wie oder größer als ein vorgegebener Wert; und
   die Filterkoeffizienten-Umschalteinheit die Filterkoeffizienten auf den zweiten Filterkoeffizientensatz umschaltet, wenn die Quantisierungs-Bitrate genauso groß ist wie oder größer als die vorgegebene Zahl und der Lautstärke-Einstellwert kleiner ist als der vorgegebene Wert.

4. Delta-Sigma-Modulator (4) nach Anspruch 1, wobei
   die Filtereinheit (11) einen Speicher enthält, der das Quantisierungsrauschen speichert; und
   wenn die Filterkoeffizienten-Umschalteinheit (17) die Filterkoeffizienten umschaltet, Inhalte des Speichers zurückgesetzt werden.

5. Delta-Sigma-Modulator (4) nach Anspruch 1, wobei
   die Filtereinheit (11) einen Speicher enthält, der das Quantisierungsrauschen speichert; und
   wenn die Filterkoeffizienten-Umschalteinheit (17) die Filterkoeffizienten so umschaltet, dass eine Ordnung derselben höher wird, Inhalte des Speichers zurückgesetzt werden.

6. Delta-Sigma-Modulator (4) nach Anspruch 1, wobei
   wenn der Lautstärke-Einstellwert verändert wird und die Verstärkung ansteigt, die Filterkoeffizienten-Umschalteinheit die Filterkoeffizienten nahe an dem Zeitpunkt umschaltet, zu dem der Anstieg beginnt; und
   wenn der Lautstärke-Einstellwert verändert wird und die Verstärkung abfällt, die Filterkoeffizienten-Umschalteinheit die Filterkoeffizienten nahe an dem Zeitpunkt umschaltet, zu dem der Abfall endet.

7. Digitaler Verstärker (20), der einen Delta-Sigma-Modulator (20) nach einem der vorangehenden Ansprüche umfasst.

8. Verfahren zum Umschalten eines Delta-Sigma-Modulators (4), um Quantisierungsrauschen eines digitalen Audiosignals zu einem Hochfrequenzband zu verschieben und Rauschen des digitalen Audiosignals zu reduzieren, wobei das Verfahren durch die folgenden Schritte **gekennzeichnet** ist:

   Erfassen einer Quantisierungs-Bitrate eines digitalen Audiosignals;

Erfassen eines Lautstärke-Einstellwertes des digitalen Audiosignals; und
Umschalten von Filterkoeffizienten gemäß der Quantisierungs-Bitrate und dem Lautstärke-Einstellwert.

**Revendications**

1. Modulateur delta-sigma (4) qui décale un bruit de quantification d'un signal audio numérique vers une bande hautes fréquences afin de réduire un bruit de la bande du signal audio numérique, le modulateur delta-sigma comprenant :

   une unité de filtrage (11) qui est configurée de manière à comporter plusieurs jeux de coefficients de filtre présentant différentes propriétés de mise en forme et permettant le passage du bruit de quantification ; et
   une unité de commutation de coefficient de filtre (17),
   **caractérisé par** :

   une unité de détection de débit binaire de quantification (9) qui est configurée pour détecter un débit binaire de quantification du signal audio numérique ; et
   une unité de détection de valeur d'établissement de volume (10) qui est configurée pour détecter une valeur d'établissement de volume du signal audio numérique,
   dans lequel l'unité de commutation de coefficient de filtre est configurée pour commuter les coefficients de filtre de l'unité de filtrage conformément au résultat de détection de l'unité de détection de débit binaire de quantification et au résultat de détection de l'unité de détection de valeur d'établissement de volume.

2. Modulateur delta-sigma (4) selon la revendication 1, dans lequel :

   les coefficients de filtre incluent un premier jeu de coefficients et un second jeu de coefficients ;
   un ordre du premier jeu de coefficients est inférieur à celui du second jeu de coefficients ; et
   l'unité de commutation de coefficient de filtre (17) commute les coefficients de filtre selon le premier jeu de coefficients lorsque le débit binaire de quantification est égal ou inférieur à un nombre prédéterminé.

3. Modulateur delta-sigma (4) selon la revendication 1, dans lequel :

   les coefficients de filtre incluent un premier jeu de coefficients et un second jeu de coefficients ;
   un ordre du premier jeu de coefficients est inférieur à celui du second jeu de coefficients ;
   l'unité de commutation de coefficient de filtre commute les coefficients de filtre selon le premier jeu de coefficients lorsque le débit binaire de quantification est égal ou supérieur à un nombre prédéterminé et que la valeur d'établissement de volume est égale ou supérieure à une valeur prédéterminée ; et
   l'unité de commutation de coefficient de filtre commute les coefficients de filtre sur le second jeu de coefficients de filtre lorsque le débit binaire de quantification est égal ou supérieur au nombre prédéterminé et que la valeur d'établissement de volume est inférieure à la valeur prédéterminée.

4. Modulateur delta-sigma (4) selon la revendication 1, dans lequel :

   l'unité de filtrage (11) inclut une mémoire, laquelle stocke le bruit de quantification ; et
   lorsque l'unité de commutation de coefficient de filtre (17) commute les coefficients de filtre, le contenu de la mémoire est remis à l'état initial.

5. Modulateur delta-sigma (4) selon la revendication 1, dans lequel :

   l'unité de filtrage (11) inclut une mémoire, laquelle mémoire stocke le bruit de quantification ; et
   lorsque l'unité de commutation de coefficient de filtre (17) commute les coefficients de filtre de telle sorte que leur ordre devienne plus grand, le contenu de la mémoire est remis à l'état initial.

6. Modulateur delta-sigma (4) selon la revendication 1, dans lequel :

   lorsque la valeur d'établissement de volume est modifiée et que le gain augmente, l'unité de commutation de coefficient de filtre commute les coefficients de filtre à proximité du point temporel lorsque la croissance démarre ; et
   lorsque la valeur d'établissement de volume est modifiée et que le gain chute, l'unité de commutation de coefficient de filtre commute les coefficients de filtre à proximité du point temporel lorsque la chute se termine.

7. Amplificateur numérique (20) comprenant un modulateur delta-sigma (4) selon l'une quelconque des revendications précédentes.

8. Procédé de commutation d'un modulateur delta-sigma (4) pour décaler un bruit de quantification d'un signal audio numérique vers une bande hautes fréquences afin de réduire le bruit du signal audio numérique, le procédé étant **caractérisé par** les étapes de :

   détection d'un débit binaire de quantification d'un signal audio numérique ;
   détection d'une valeur d'établissement de volume du signal audio numérique ; et
   commutation des coefficients de filtre conformément au débit binaire de quantification et à la valeur d'établissement de volume.

# FIG. 1
# PRIOR ART

# FIG. 2
## PRIOR ART

m-BIT SIGNAL
INPUT TERMINAL

n-BIT SIGNAL
OUTPUT TERMINAL

108

101
ADDER

QUANTIZER

107

109

106

ADDER
102

VARIABLE
FILTER

103

104

LEVEL
DETECTION
UNIT

LEVEL
DETERMINATION
UNIT

FILTER
COEFFICIENT
STORAGE
MEMORY

105

EP 1 424 780 B1

# FIG. 3

EP 1 424 780 B1

```
    1                    2                    3                    4
┌──────────────┐    ┌──────────────┐    ┌──────────────┐    ┌──────────────┐
│   DIGITAL    │    │ OVER-SAMPLING│    │   DIGITAL    │    │ DELTA-SIGMA  │
│  INTERFACE   │───▶│   CIRCUIT    │───▶│   VOLUME     │───▶│  MODULATOR   │
└──────────────┘    └──────────────┘    └──────────────┘    └──────────────┘

                                                                    │
                                                                    ▼
┌──────────────┐    ┌──────────────┐    ┌──────────────┐    ┌──────────────┐
│   LOW-PASS   │◀───│ POWER SWITCH │◀───│   PCM/PWM    │◀───│              │
│    FILTER    │    │              │    │  CONVERTER   │
└──────────────┘    └──────────────┘    └──────────────┘
      7                    6                    5
```

# FIG. 4

768kHz SAMPLING
24bit
X(z)

$+$

$\Sigma$

$-$

QUANTIZER

768kHz SAMPLING
6bit
$Y(z)=X(z)+N'q(z)$

$-$ $\Sigma$ $+$

FILTER
H(z)

Nq(z)

EP 1 424 780 B1

# FIG. 5

COEFFICIENT BITS: 24

## FIG. 6

QUANTIZATION BIT RATE DETECTION UNIT — 9

VOLUME SETTING VALUE DETECTION UNIT — 10

INPUT

SWITCHING

QUINTIC FILTER COEFFICIENT SET

TERTIARY FILTER COEFFICIENT SET

QUANTIZER

OUTPUT

$a_5$ 12

$a_4$ 13

$a_3$ $b_3$ 14

$a_2$ $b_2$ 15

$a_1$ $b_1$ 16

$Z^{-1}$ 18

$Z^{-1}$ 19

$Z^{-1}$ 20

$Z^{-1}$ 21

$Z^{-1}$ 22

17

11

4

EP 1 424 780 B1

## FIG. 7

MAXIMUM VALUE OF VOLUME

NEW SETTING VALUE

-6db

THRESHOLD VALUE

VOLUME SETTING VALUE

CURRENT SETTING VALUE

FILTER COEFFICIENT SWITCHING
QUINTIC→TERTIARY

TIME

## FIG. 8

MAXIMUM VALUE OF VOLUME

CURRENT SETTING VALUE

-6db

THRESHOLD VALUE

VOLUME SETTING VALUE

NEW SETTING VALUE

FILTER COEFFICIENT SWITCHING
TERTIARY→QUINTIC

TIME

# FIG. 9

QUANTIZER → $Y(z)=X'(z)+N'q(z)$

FILTER $G(z)$

FILTER $F(z)$ ← $Nq(z)$

$X(z)$

$X'(z)=G(z)X(z)$

$N'q(z)=(1-F(z)G(z))Nq(z)$

EP 1 424 780 B1

# FIG. 10

X(z) → [+] Σ [−] → FILTER G(z) → QUANTIZER → Y(z)=X'(z)+N'q(z)

FILTER F(z)

$$X'(z) = \frac{G(z)}{1+F(z)G(z)} X(z)$$

$$N'q(z) = \frac{1}{1+F(z)G(z)} Nq(z)$$

EP 1 424 780 B1